# EUROPEAN PATENT APPLICATION

(11) **EP 2 549 840 A1**
(43) Date of publication of application: **23.01.2013**
(21) Application number: 11756029.2
(22) Date of filing: 21.02.2011
(51) Int. Cl.: H05H 1/46, C23C 16/509, H01L 21/205, H01L 21/3065

(54) **PLASMA PROCESSING DEVICE, PLASMA PROCESSING METHOD, AND METHOD FOR MANUFACTURING A SEMICONDUCTOR ELEMENT**

(30) Priority: 15.03.2010 JP 2010057706
(71) Applicant: Sharp Kabushiki Kaisha, Osaka-shi, Osaka 545-8522 (JP)
(72) Inventor: YOKOGAWA, Masahiro, Osaka 545-8522 (JP); ISSHIKI, Kazuhiko, Osaka 545-8522 (JP); KISHIMOTO, Katsushi, Osaka 545-8522 (JP)
(74) Representative: Müller - Hoffmann & Partner
(86) International application number: PCT/JP2011/053714
(87) International publication number: WO 2011/114840

(57) **Abstract**

A plasma treating apparatus comprising: a sealable chamber into which a reactive material gas is introduced; plural sets of discharging parts, each set having a cathode and an anode aligned in an opposite manner in the chamber to generate a plasma discharge; an electric source part positioned outside the chamber to supply electric power for generating the plasma discharge in the plural sets of discharging parts; a plurality of matching boxes positioned outside the chamber, the matching boxes electrically connected to the electric source part; at least a supporting part positioned outside the chamber, the supporting part supporting the plural matching boxes; and a plurality of electric conductors which electrically connect the plural matching boxes to the cathodes of the plural sets of discharging parts, wherein the supporting part is adapted to support one or more of the matching boxes at a position where the plurality of electric conductors are equal in length.

## Description

### TECHNICL FIELD

The present invention relates to a plasma treating apparatus equipped with plural sets of discharging parts comprising a pair of cathode and anode in a chamber, to a plasma treating method and a method for manufacturing a semiconductor device using the same. More particularly, the plasma treating apparatus of the present invention is equipped with a matching box to equivalently supply the electric power from the electric source to each cathode via an electric conductor and a supporting part supporting the matching box.

### BACKGROUND ART

As to the conventional plasma treating apparatus, a vertical type where cathode and anode are aligned in a vertical direction (refer, for example, to Patent Document 1) and a horizontal type where cathode and anode are aligned in a horizontal direction (refer, for example, to Patent Document 2) have been proposed. Those plasma treating apparatuses are equipped with a tightly-sealable chamber into which reactive material gas is introduced, a plurality of sets of discharging parts comprising a pair of cathode and anode which are oppositely aligned in the chamber and generating the plasma discharge and an electric source part which is aligned outside the chamber and supplies electric power to all sets of discharging part.

The above vertical plasma treating apparatus is further equipped with a matching box which matches the impedance between the electric source part and the cathode. Further, in the vertical plasma treating apparatus, an electric power introducing line between the matching box and the cathode is symmetrically branched in the same numbers as the cathode numbers for conducting an equivalent supply of electric power to each discharging part.

In the above horizontal plasma treating apparatus, cathodes of the adjacent two discharging parts are connected to the same electric source part via separate amplifiers respectively or are connected to the different electric power sources via amplifiers respectively. As a result, each of the cathodes in the adjacent discharging part is connected to an electric source part via electric systems being different each other whereby equivalent electric power is supplied to each discharging part without the use of a matching box.

### PRIOR ART DOCUMENTS

### PATENT DOCUMENTS

Patent Document 1: JP 2006-196681A
Patent Document 2: JP 2009-283235A

### SUMMARY OF THE INVENTION

### PROBLEMS TO BE SOLVED BY THE INVENTION

Generally, a matching box is a heavy thing (about 10 kg). Therefore, it is questionable in view of safety in using a matching box that a matching box is aligned and fixed to the top or to the side of a chamber since load is applied to the chamber thereby. However, with regard to a safe and suitable aligning method of the matching box, there has been no specific proposal up to now.
The present invention has been achieved in view of the problem as such and an object thereof is to provide a plasma treating apparatus in which a matching box is able to safely and appropriately aligned.

### MEANS FOR SOLVING THE PROBLEMS

The present invention was made in view of the above problems, and it is an object of the present invention to provide a plasma treating apparatus comprising:
a sealable chamber into which a reactive material gas is introduced;
plural sets of discharging parts, each set having a cathode and an anode aligned in an opposite manner in the chamber to generate a plasma discharge;
an electric source part positioned outside the chamber to supply electric power for generating the plasma discharge in the plural sets of discharging parts;
a plurality of matching boxes positioned outside the chamber, the matching boxes electrically connected to the electric source part;
at least a supporting part positioned outside the chamber, the supporting part supporting the plural matching boxes; and
a plurality of electric conductors which electrically connect the plural matching boxes to the cathodes of the plural sets of discharging parts,
wherein the supporting part is adapted to support one or more of the matching boxes at a position where the plurality of electric conductors are equal in length.

In accordance with another aspect of the present invention, there is provided a plasma treating method wherein a substrate is placed at the discharging part in the plasma treating apparatus so that a semiconductor membrane is layered on the surface of the substrate or where a substrate having a semiconductor membrane on the surface is placed at the discharging part so that the semiconductor membrane on the substrate is etched.
In accordance with still another aspect of the present invention, there is provided a method for manufacturing a semiconductor device wherein a semiconductor device is formed on the substrate using the plasma treating method.

### EFFECTS OF THE INVENTION

According to the plasma treating apparatus, it is possible that a matching box which is a heavy thing in general is stably and safely installed without causing a load to a chamber. In other words, a matching box is able to be appropriately installed in a position wherefrom equivalent electric power is supplied to each discharging part.
As a result, imbalance of the device characteristics is able to be suppressed and the semiconductor device is able to be stably produced in desired characteristics when a semiconductor device such as thin-membrane solar battery using semiconductor thin membrane or optical thin membrane, TFT or photosensitive material where the plasma treating apparatus of the present invention is used.

### BRIEF DESCRIPTION OF THE DRAWINGS

Fig. 1 is a rough constitutional drawing which shows an embodiment 1 of the plasma treating apparatus of the present invention.
Fig. 2 is a constitutional drawing which shows the first electric conductor and the first case of the plasma treating apparatus according to the embodiment 1.
Fig. 3 is a rough constitutional drawing which shows an embodiment 2 of the plasma treating apparatus of the present invention.
Fig. 4 is a rough constitutional drawing which shows an embodiment 3 of the plasma treating apparatus of the present invention.
Fig. 5 is a rough constitutional drawing which shows an embodiment 4 of the plasma treating apparatus of the present invention.
Fig. 6 is a constitutional drawing which shows the first electric conductor and the first case of the plasma treating apparatus according to the embodiment 5.
Fig. 7 is a rough constitutional drawing which shows an embodiment 6 of the plasma treating apparatus of the present invention.
Fig. 8 is a rough constitutional drawing which shows an embodiment 7 of the plasma treating apparatus of the present invention.
Fig. 9 is a rough constitutional drawing which shows an embodiment 8 of the plasma treating apparatus of the present invention.
Fig. 10 is a rough constitutional drawing which shows an embodiment 9 of the plasma treating apparatus of the present invention.
Fig. 11 is a rough constitutional drawing which shows an embodiment 10 of the plasma treating apparatus of the present invention.

### MODE FOR CARRYIN OUT THE INVENTION

As mentioned above, the plasma treating apparatus of the present invention comprises a chamber, plural sets of discharging parts having a pair of cathode and anode generating the plasma discharge, an electric source part which supplies electric power generating the plasma discharge in plural sets of discharging parts, plural matching boxes which are electrically connected to the electric source part, at least one supporting part which supports plural matching boxes and plural electric conductors which are electrically connect plural matching boxes to cathodes of plural sets of discharging parts.
The supporting part is constituted in such a manner that one or more matching boxes are supported at the position where the plurality of electric conductors are equal in length.
The term "electric conductor" used here stands for the whole wiring from the matching box to the cathode.
The matching box is aligned in a route for supplying the electric power between the electric source part and each cathode and is an impedance matching apparatus, which is commonly used in the related art, for matching the impedance between the electric source part and each cathode. Although each of the electric source parts being synchronized each other may be connected to a matching box, it is also possible that a matching box is connected to each of the electric power supplying routes branched in two or more from the same electric source part.

Thus, this plasma treating apparatus is constituted in such a manner that a matching box is supported via a supporting part on a floor of the place where a plasma treating apparatus is installed for avoiding the load to a chamber caused by installment of a heavy matching box in a ceiling or a side face of a chamber.
When length of each electric conductor from each matching box to each cathode is different at that time, the impedance between the electric source part and each cathode is unbalanced whereby electric power supplied to each discharging part is unbalanced and, as a result, it is no longer possible to equivalently conduct the plasma treatment in each discharging part. Therefore, the supporting part is constituted so as to support one or more matching box(es) at the position where lengths of a plurality of electric conductors are able to be made equal.
Incidentally, at least one of the plural matching boxes may be installed directly on the floor.

In the plasma treating apparatus of the present invention, direction of an electrode may be either horizontal or vertical. Further, the plasma treating apparatus according to the present invention is applicable to a plasma treating apparatus of a membrane preparation type where a membrane (such as semiconductor membrane) is prepared on a substrate and also to a plasma treating apparatus of an etching type where a membrane (such as semiconductor membrane) on a substrate is subjected to etching.
The above plasma treating apparatus may also be constituted as shown in the following (1) to (10) and each of them may also be appropriately combined.

(1) The support is installed on the floor of a place where the plasma treating apparatus is installed and has a fixed stand or a height-adjustable elevating stand by which the matching box is able to be supported at the height being able to make the lengths of a plurality of electric conductors same.
As a result thereof, a matching box is able to be easily installed at the above height from the floor via a support and, at the same time, a route for supplying the electric power using the electric conductor does not become complex but is able to be simplified.
Further, when it is not necessary to adjust the electrode interval between cathode and anode, the interval between the adjacent discharging parts, etc., there is no need of adjusting the height for the installment of a matching box in a later stage. Therefore, a matching box is able to be easily and quickly installed at the predetermined installing height using a fixed stand.

On the other hand, when it is necessary to adjust the electrode interval between cathode and anode, to adjust the interval between the adjacent discharging parts, etc., the height for the installment of a matching box is to be also adjusted. Therefore, the constitution where the installing height of a matching box is able to be easily adjusted using an elevating stand (such as a jack) is preferred.
In that case, a matching box is able to be easily moved to the safe height where the workers easily operate it even during the maintenance of the matching box whereby the danger in a high-place work and in descending a heavy matching box is able to be reduced.

(2) The plasma treating apparatus has the matching boxes in the numbers of "n" (n is a natural number of 2 or more) and, in the chamber, there are the cathodes in the numbers of "n × 2^{m}" (m is a natural number) and each of the matching boxes in the numbers of "n" is connected to the cathodes in the numbers of "2^{m}" via the electric conductor.
As a result thereof, the numbers of cathodes connecting to each matching box are able to be made same.

(3) The electric conductor comprises a transmitting wiring, a connecting wiring and a branching wiring, each of both ends of the branching wiring is electrically connected to the cathode each being different, an end of the transmitting wiring is electrically connected to the matching box, an end of the connecting wiring is electrically connected to another end of the transmitting wiring and another end of the connecting wiring is electrically connected to the point being in the same distance from both ends of the branching wiring.
As a result thereof, electric power is able to be equivalently supplied to each discharging part even if the numbers of the electric source parts and the matching boxes are reduced whereby the plasma treating apparatus is able to be made simple and less expensive.
In the case of a plasma treating apparatus of a horizontal type, a transmitting wiring is able to be aligned in a vertical direction and a connecting wiring is able to be aligned in a horizontal direction. In the case of a plasma treating apparatus of a vertical type, a transmitting wiring is able to be aligned in a horizontal direction and a connecting wiring is able to be aligned in a vertical direction. Therefore, degree of freedom for the installing position of a matching box increases.

(4) The electric conductor comprises a connecting wiring and a branching wiring, each of the both ends of the branching wiring is electrically connected to the cathode each being different, an end of the connecting wiring is electrically connected to the matching box and another end of the connecting wiring is electrically connected to the point being in the same distance from the both ends of the branching wiring.
This constitution is a connecting embodiment where the transmitting wiring of (3) is omitted and the connecting wiring is directly connected to the matching box.

Even in such a case, equivalent electric power is able to be supplied to each discharging part even if the numbers of the electric source parts and the matching boxes are reduced the same as in (3) whereby the plasma treating apparatus is able to be made simple and less expensive.
Further, since the electric power supplying route from the matching box to the cathode becomes short, consumption of electric power caused by wiring resistance of the electric power supplying route is able to be reduced. Moreover, since the connecting places for different wirings reduce, consumption of electric power caused by contact resistance is able to be reduced.
As a result thereof, supplying efficiency of the electric power is able to be enhanced.

(5) The branching wiring is constituted in m stages from the connecting wiring side to the cathode side by branched lines in the numbers of 2^{m-1} (m is a natural number),
both ends of each of the branched lines except that of the m-th stage are electrically connected to a point being in the same distance from both ends of the branched line of the next stage each being different and
both ends of the branching wiring of the m-th stage are electrically connected to cathodes each being different.
As a result thereof, equivalent electric power is able to be supplied to each discharging part even if the numbers of cathode in relation to the numbers of electric source parts and the matching boxes increase whereby the treating ability of the plasma treating apparatus is enhanced.

(6) The electric conductor comprises a connecting wiring and a transmitting wiring, an end of the transmitting wiring is electrically connected to the matching box, an end of the connecting wiring is electrically connected to another end of the transmitting wiring and another end of the connecting wiring is electrically connected to the cathode.
This constitution is such a connecting mode where the branching wiring of (2) and (3) is omitted and the connecting wiring is electrically connected to the cathode directly.
As a result thereof, cathode and matching box are able to be connected in 1:1. Therefore, even in such a state where only cathode or anode of the discharging part being out of order is taken out from the inside of the chamber, a plasma treatment of a substrate by other discharging part is able to be conducted.

(7) Each of the above plural different electric conductors is constituted from the same material and structure as a whole.
In that case, "structure" covers size, shape, bending position and connecting structure and means such a structure where, in the same electric conductor, a plurality of branching wirings are symmetrically aligned.
As a result thereof, it is possible that the imbalance of impedance between matching box and cathode is further reduced and that supply of electric power to each discharging part is conducted more uniformly.
Further, with regard to a branching wiring, a connecting wiring and a transmitting wiring, each of them is able to use the same parts whereby effects of improvement in maintenance and of cost reduction are achieved due to standardization of the parts for each.

(8) A part of or all of the plural electric conductors is/are constituted from those in a form of tube, plate or square rod.
As a result thereof, loss in electric power is able to be reduced.
That is, in alternating current, a skin effect where the current flows intensively upon nearer the surface of the electric conductor is resulted when frequency becomes higher. Accordingly, in electric current of high frequency, there is a property where it flows only near the surface of the conductive material due to the skin effect.
Accordingly, when electric power of high frequency is supplied to a common circular solid electric conductor where the cross section is circular solid, electric resistance near the center of the circular solid electric conductor increases whereupon the electric current flows only near the surface of the circular solid electric conductor. As a result, electric resistance of the circular solid electric conductor as a whole becomes high and loss of electric power increases.

In view of the above, as a result of preparing a tubular electric conductor having a hollow structure, surface area of inner surface of the hollow part increases and electric current in high frequency is more apt to flow as compared with circular solid electric conductor to an extent of an increased surface area whereby loss of electric power is able to be reduced.
Further, as a result of an increase in the surface area of the tubular electric conductor, heat releasing property is enhanced whereby a rise in temperature of the electric conductor upon supplying the high-frequency electric power is able to be suppressed and loss of electric power resulted by a rise in electric resistance by heat is able to be reduced.

In an electric conductor in a plate shape (such as that where the cross section is rectangular solid, long-circular solid or elliptic solid), its surface area is also more than the circular solid electric conductor whereby, due to the same reason as in the tubular electric conductor, electric power loss upon supplying the high-frequency electric power is able to be reduced as compared with circular solid electric conductor.
Further, when surface area of electric conductor in square rod shape (such as that where the cross section is regular square solid) and surface area of circular solid electric conductor are compared under the condition of same volume (cross section × length), surface area of electric conductor in square rod shape is about 3.4 times of surface of circular electric conductor. Accordingly, due to the same reason as in tubular electric conductor, electric power loss upon supplying the high-frequency electric power is able to be reduced as compared with circular solid electric conductor.

(9) The electric conductor comprises a metal material containing at least one of copper, aluminum, nickel, silver, gold and tin.
(10) A case which contains a part of or all of the above electric conductor(s) is further equipped therewith.
As a result thereof, leakage of high frequency to the outside from the electric conductor upon supplying the high-frequency electric power is able to be prevented and, at the same time, occurrence of an accident where a worker erroneously touches the electric conductor upon supplying the electricity is able to be prevented.

Hereinafter, embodiments of the plasma treating apparatus according to the present invention will be illustrated by referring to the drawings. Incidentally, the present invention is not limited to the embodiments shown by the drawings.

### (Embodiment 1)

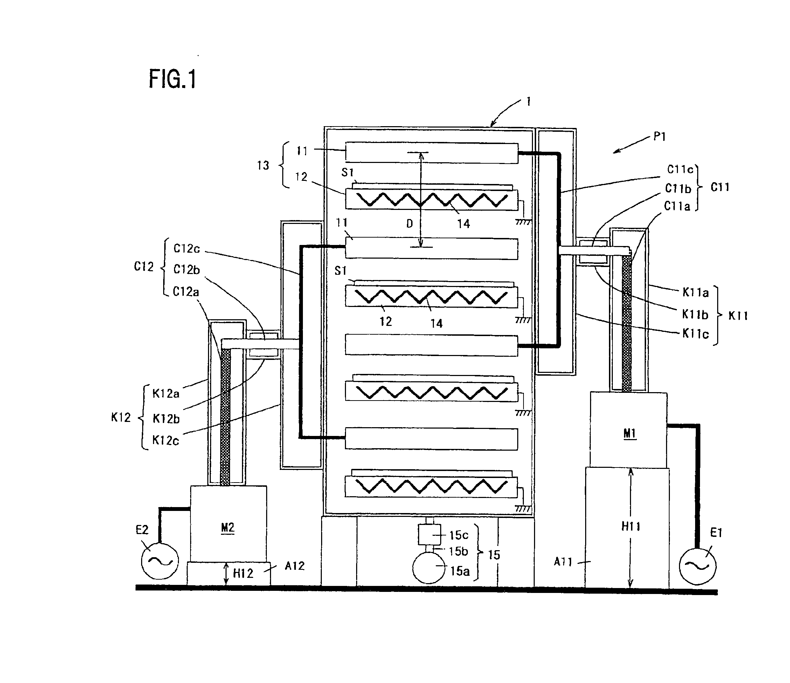

Fig. 1 is a rough constitutional drawing which shows the embodiment 1 of the plasma treating apparatus according to the present invention.
The plasma treating apparatus P1 of the embodiment 1 is a plasma treating apparatus of a horizontal type and it is equipped with a sealable chamber 1, a gas-introducing part (not shown) which introduces the reaction gas into the chamber 1, an exhaust part 15 which discharges the reaction gas from the chamber 1, four sets of discharging parts 13 comprising a set of cathode 11 and anode 12 which are aligned horizontally and facing each other in the chamber 1 and conducting the plasma discharge, electric source parts E1 and E2 which supply electric power to each discharging part 13, matching boxes M1 and M2 which are electrically connected to each of electric source parts E1 and E2, supporting parts A11 and A 12 which support each of the matching boxes M1 and M2, electric conductors C11 and C 12 which electrically connect each of the matching boxes M 1 and M2 to cathode 11 of the discharging part 13 and cases K11 and K12 which cover nearly whole of each of the electric conductors C11 and C12. In this plasma treating apparatus P1, a substrate S1 may be installed in an anode 12 of each discharging part 13 and a semiconductor membrane is layered on the surface of the substrate S1 to form a semiconductor device.

The chamber 1 has leg parts and is formed in a longitudinal box type having a door (not shown) being able to open and close on the front side. Further, the chamber 1 is installed with the support pieces (not shown) on its left and right inner wall sides supporting each cathode 11 and each anode 12 with a predetermined interval and an exhaust part 15 is connected to the bottom of the chamber 1. Incidentally, the space between an anode 12 of one discharging part 13 and a cathode 11 of the adjacent another discharging part 13 is also made in a predetermined interval.

On the outside of the left and right walls of the chamber 1, there are aligned cases K11 and K12 comprising an electric conductor such as aluminum or copper for containing the electric conductors C11 and C12.
The cases K11 and K12 are to prevent the leakage of high frequency to the outside from the electric conductors C11 and C12 upon supplying the high-frequency electric power and also to prevent the occurrence of such an accident that a worker erroneously touches the electric conductors C11 and C 12 to which electricity is applied.

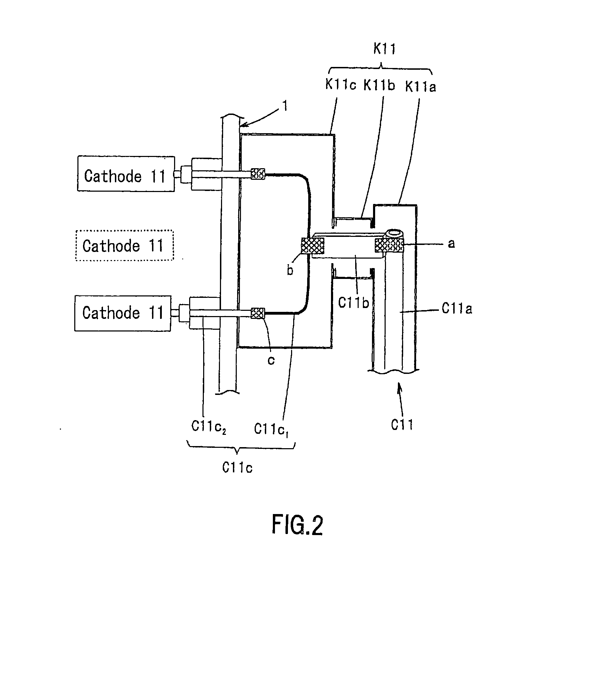

Fig. 2 is a constitutional drawing which shows the first electric conductor and the first case of the plasma treating apparatus of the embodiment 1.
As shown in Figs. 1 and 2, one of the cases K11 (hereinafter, it will be referred to as "the first case") comprises the first part K11a which is long in vertical direction being installed on one of the matching boxes M1 (hereinafter, it will be referred to as "the first matching box"), the second part K11b being connected to an upper end of the first part K11a of the side of the chamber 1 and the third part K11c connecting the second part K11b to the side wall of the chamber 1 and, in those connecting parts, insertion pore for inserting the electric conductor C11 is formed.

The same as in the first case K11, another case (hereinafter, it will be referred to as "the second case") K12 also comprises the first part K12a being installed on another matching box M2 (hereinafter, it will be referred to as "the second matching box"), the second part K12b being connected to an upper end of the first part K12a of the side of the chamber 1 and the third part K12c connecting the second part K12b to the side wall of the chamber 1 and, in those connecting parts, insertion pore for inserting the electric conductor C12 is formed.
The first and the second cases K11 and K12 will be further illustrated later.

Each cathode 11 has the same constitution while each anode 12 has the same constitution.
The cathode 11 is prepared from stainless steel, aluminum alloy, etc. Size of each cathode 11 is set at an appropriately value depending upon the size of the substrate S1 where membrane is formed and may be designed in the same size (plane size and thickness) as the anode 12.
In a cathode 11, its inner area is hollow and, in a plasma discharge surface facing an anode 12 to be paired, many perforations connecting to the above hollow part are formed by means of a perforating process. This perforating process is preferred to be conducted in such a manner that circular pores of 0.1 to 2 mm diameter are formed with intervals of several millimeters to several centimeters.

On an end surface of the cathode 1, there is connected a gas introducing pipe as a gas introducing part (not shown). A gas supplying source (not shown) and a gas introducing part are connected by a connecting pipe. Accordingly, when reaction gas is supplied from gas supply source to the hollow formed in the inner area of the cathode 11, the reaction gas is blown out from the above-mentioned many perforated pores onto the surface of the substrate S1 on the anode 12.
As to the reaction gas (material gas) for preparing the membrane, that which meets the material of the membrane to be prepared is used. For example, when membrane is formed for a semiconductor membrane of a silicon type where impurities are doped, there are used PH₃ (phosphine) gas, B₂H₆ (diborane) gas, CO₂ gas, etc. together with SiH₄ (monosilane) gas diluted with H₂.

The anode 12 has a heater 14 inside and, on the upper surface thereof, a substrate S1 is installed and, during the formation of the membrane under the plasma discharge, the substrate S1 is heated. As to the substrate S1, it is common to use a semiconductor substrate (such as silicon substrate), a glass substrate, etc. although the present invention is not limited thereto.
An anode 12 is prepared by a material having electric conductivity and heat resistance such as stainless steel, aluminum alloy, carbon or the like.

Size of the anode 12 is appropriately decided to meet the size of the substrate S1 for preparing the thin membrane. For example, when the size of the substrate S1 is 900∼1200 mm × 400∼900 mm, the size of the anode 12 is designed to be 1000∼1500 mm × 600∼1000 mm.
Alternatively, a plurality of substrates S1 may be installed by setting out on one anode 12. For example, when the size of the anode 12 is 1500 mm × 1000 mm, two substrates S1 each having a size of 700 mm × 1000 mm may be installed by setting out thereon or four substrates S 1 each having a size of 700 mm × 400 mm may be installed by setting out in two rows.

The heater 14 being built in the anode 12 is to control the heating of the anode 12 from room temperature to 300°C and, for example, there may be used an aluminum alloy in which a heating apparatus of a tightly closed type such as a sheath heater and a temperature sensor of a tightly closed type such as a thermocouple are built.
Although a heater 14 is built in an anode 14 in the embodiment of the present invention, a constitution where a heater 14 and an anode 12 are installed separately is also acceptable. In that case, the heater 14 is preferred to be constituted in such a manner that it is able to uniformly heat the substrate S1 throughout the surfaces. For example, a heater in a plate shape may be installed on the back of the side on which a substrate S 1 of the anode 12 is installed.

An electric conductor (hereinafter, it will be referred to as "the first electric conductor") C11 which is contained in the first case K 11 is equipped with a transmitting wiring C11a which has a lower end being electrically connected to the first matching box M1 and is aligned in a vertical direction, a connecting wiring C11b which has an end being electrically connected to an upper end of the transmitting wiring C11a via a fastening part "a" and a branching wiring C11c which is electrically connected to another end of the connecting wiring C11b via a fastening part "b".
The transmitting wiring C 11 a comprises a tubular electric conductor made of metal and is contained in the first part K11a.
The connecting wiring C11b comprises a plate-shaped electric conductor made of metal and is contained from the first part K11a to the third part K11c throughout.

The branching wiring C11c is constituted from the first wire C11c₁ comprising the common leading wire (such as copper wire) and the second wire C11c comprising a rod-shaped electric conductor made of metal being electrically connected to both ends of the first wire C11c₁ via a fastening member "c".
The first wire C11c₁ is contained in the third part K11c while the second wire C11c₂ penetrates the side wall of the chamber 1 from the third part K11c and is electrically connected to a cathode 11 in the reaction chamber.
Further, a point which is in the same distance from both ends of he branching wiring C11c (a midpoint which is in the same distance from both ends of the first wire C11c₁) is electrically connected to the connecting wiring C11b.
Still further, the branching wiring C11c is bent in a linearly symmetric manner at the point which is in the same distance from the connecting part to the connecting wiring C11b and is electrically connected at the same positions on one end surfaces (right-end surfaces) of the first and the third (counting from up to down) cathodes 11.
Incidentally, all anodes 12 are earthed.

Another electric conductor (hereinafter, it will be referred to as "the second electric conductor") C 12 is the same as the first electric conductor C11, is equipped with a transmitting wiring C12a being electrically connected to the second matching box M2, the connecting wiring C12b being electrically connected to the transmitting wiring C12a via a fastening part and a branching wiring C11c being electrically connected to the connecting wiring C11b via a fastening part and is contained in the second case K12.
Thus, the length from the lower end (the connecting part to the first matching box M1) of the transmitting wiring C11a of the first electric conductor C11 to the front end (the connecting part to the cathode 11) of the branching wiring C11c and the length from the lower end (the connecting part to the second matching box M2) of the transmitting wiring C12a of the second electric conductor C12 to the front end (the connecting part to the cathode 11) of the branching wiring C12c are same. Further, positions and numbers of the bending part in the first electric conductor C 11 and positions and numbers of the bending part in the second electric conductor C12 are same. Hereinabove, a bending part in the case of the first electric conductor C11 means a part which is bent in the electric conductor such as a connecting part of the transmitting wiring C11a to the connecting wiring C11b, a connecting part of the connecting wiring C11b to the branching wiring C11c and a folded part of the branching wiring C11c. That is the same in the second electric conductor C12 as well.
However, both ends of the branching wiring C12c of the second electric conductor C12 are electrically connected to the midpoints in the longitudinal direction of other end surfaces (left end surfaces) of the second and the fourth (counting from the upside) cathodes 11.
As a result thereof, the second electric conductor C 12 electrically connects to each cathode 11 without interfering with the first electric conductor C11c and in the same position as in the first electric conductor C11c.
Incidentally, in the embodiment 1 and the embodiments thereafter, the transmitting wiring and the branching wiring may be an electric conductor in a shape of plate or square rod.

An exhaust part 15 is equipped with a vacuum pump 15a, an exhaust pipe 15b connecting the vacuum pump 15a and the inner area (reaction chamber) of the chamber 1 and a pressure controller 15c aligned on the exhaust pipe 15b between the chamber 1 and the vacuum pump 15a.
In the case of this embodiment, an exhaust part 15 is connected to the bottom of the chamber 1 in one place but the connecting place of the exhaust part 15 is not limited to the bottom and, moreover, a plurality of exhaust parts 15 may be equipped therewith. For example, exhaust parts 15 may be installed in two places (upper and lower sides) which are ceiling and bottom of the chamber 1. As a result of installing the exhaust parts 15 in two places as such, the atmosphere in each of upper and lower sides of the inner area of the chamber 1 is now able to be efficiently exhausted.
The first matching box M1 matches the impedances between the electric source part E1 and the first cathode 11 and also between the electric source part E1 and the third cathode 11. The second matching box M2 matches the impedances between the electric source part E2 and the second cathode 11 and also between the electric source part E2 and the fourth cathode 11. The first matching box M 1 and the second matching box M2 are the same thing and their height is same.

Electric source parts E1 and E2 are plasma excitation electric sources equipped with a high-frequency generator and an amplifier which amplifies the high-frequency electric power from the high-frequency generator and supplies it to a cathode 11. For example, electric power of 10 W to 100 kW in AC 1.00 MHz to 60 MHz frequency or, to be more specific, electric power of 10 W to 10 kW in 13.56 MHz to 60 MHz is supplied to each cathode 1.
The embodiment 1 exemplifies the case where separate electric source parts E1 and E2 being synchronized each other are used although it is also possible that electric power supplying route from one electric source part is branched and connects to each of the first and the second matching boxes M1 and M2.

A supporting part (hereinafter, it will be referred to as "the first supporting part") A11 which supports the first matching box M1 is a fixing stand fixed on a floor on which the plasma treating apparatus P1 is installed and it has a predetermined height H 11.
A supporting part (hereinafter, it will be referred to as "the second supporting part") A 12 which supports the second matching box M2 is a fixing stand fixed on the above-mentioned floor and it has a predetermined height H12.
Although the first electric conductor C 11 and the second electric conductor C12 are same, the height of a connecting part of the connecting wiring C11b to the branching wiring C11c of the first electric conductor C11 and the height of a connecting part of the connecting wiring C12b to the branching wiring C12c of the second electric conductor C12 have a difference corresponding to the interval D between the adjacent two cathodes 11.
Accordingly, the height H11 of the first supporting part A11 is set higher to an extent of the above interval D than the height H12 of the second supporting part A12. In other words, H11 - H12 = D.
Incidentally, with regard to the first and the second supporting parts A11 and A12, elevating stands may be used instead of fixed ones.

In accordance with the plasma treating apparatus P1 constituted as such, an electric power supplying route from the first matching box M 1 to the first and the third cathodes 11 and an electric power supplying route from the second matching box M2 to the second and the fourth cathodes 11 are identical whereby imbalance between the high-frequency electric power to be supplied from the electric source E1 to the first and the third cathodes 11 and the high-frequency electric power to be supplied from the electric source E2 to the second and the fourth cathodes 11 are able to be reduced.
As a result, the imbalance in the plasma discharge of each discharging part 13 under the reaction gas atmosphere is reduced and, accordingly, uniformity of quality of the membrane (such as semiconductor membrane) formed on each substrate for the membrane formation (such as semiconductor substrate) set on each anode 12 is able to be enhanced.
Incidentally, in the embodiment 1 and the embodiments thereafter, cathodes in the adjacent discharging parts may be connected by the same electric conductor.

### (Embodiment 2)

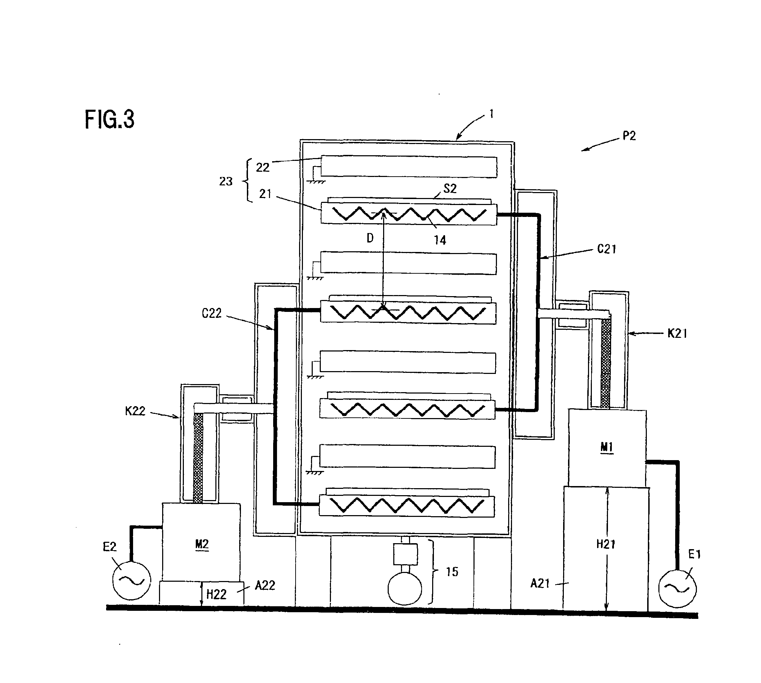

Fig. 3 is a rough constitutional drawing which shows an embodiment 2 of the plasma treating apparatus according to the present invention. In Fig. 3, an element which is the same as the element in Fig. 1 is assigned with the same reference.
The plasma treating apparatus P2 of the embodiment 2 is a plasma treating apparatus for etching. In this plasma treating apparatus P2, the discharging part 23 is constituted from an anode 22 aligned upside and a cathode 21 aligned downside. A cathode 21 of each discharging part 23 is connected to the first and the second electric conductors C21 and C22 and an anode 22 of each discharging part 23 is earthed.

In that case, the cathode 21 is substantially same as the anode 12 mentioned in Fig. 1 in terms of the structure while the anode 22 is substantially same as the cathode 11 mentioned in Fig. 1 in terms of the structure and the reaction gas is supplied to the anode 22.
As to the reaction gas for etching at that time, the reaction gas corresponding to the material of the membrane to be etched is used. For example, in etching a semiconductor membrane of a silicon type, a fluorine type one such as CF₄ or C₄F₈ diluted with inert gas such as Ar is used mostly.

In this plasma treating apparatus P2, the constitution of the first and the second electric conductors C21 and C22 and the constitution of the first and the second cases K21 and K22 are fundamentally same as those in the embodiment 1 and other constitutions are also the same as those in the embodiment 1.
Thus, the distances from the first and the second matching boxes M 1 and M2 to each cathode 21 are same. Further, the distance from the first matching box M 1 to each bending part of the first electric conductor C21 and the distance from the second matching box M2 to each bending part of the second electric conductor C22 are also same.
The first and the second electric conductors C21 and C22 are constituted as such and, at the same time, positions of the heights of the first and the second matching boxes M 1 and M2 are adjusted by the first and the second supporting parts A21, A22 (H21 - H22 = D).
Incidentally, when the height H21 of the first supporting part A21 is identical with the cathode interval D, it is possible that the second supporting part A22 is omitted and the second matching box M2 is directly installed on the floor.
In accordance with this plasma treating apparatus P2, imbalance in plasma discharges of each of the discharging parts 23 under the reaction gas atmosphere is able to be reduced and the uniformity of etching of each substrate for etching (such as semiconductor substrate) installed in each cathode 21 is able to be enhanced.
Incidentally, in the following embodiments, the side where the substrate is installed may be used as a cathode the same as in the embodiment 2.

### (Embodiment 3)

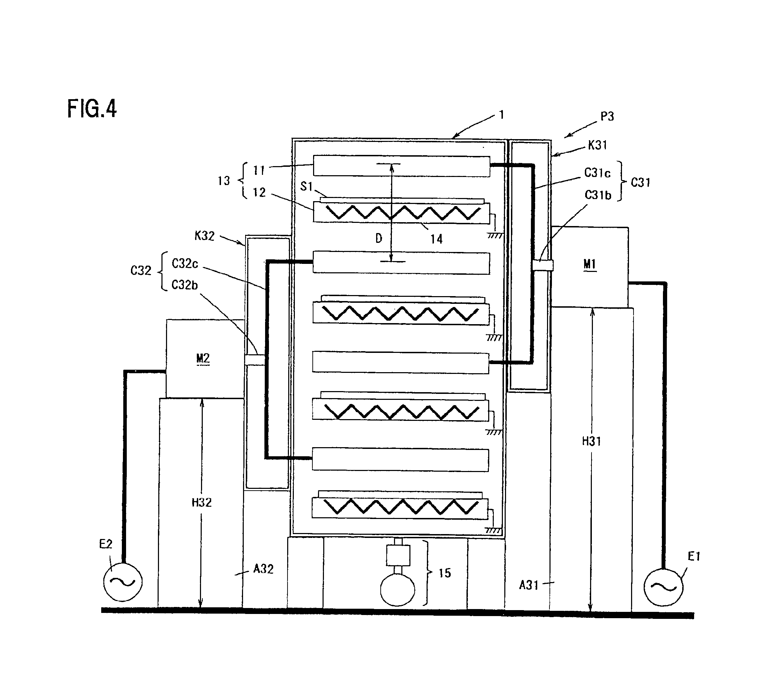

Fig. 4 is a rough constitutional drawing which shows an embodiment 3 of the plasma treating apparatus of the present invention. In Fig. 4, an element which is the same as that in Fig. 1 is assigned with the same reference.
The difference in the plasma treating apparatus P3 in the embodiment 3 from the embodiment 1 is mostly that a transmitting wiring is omitted from the first and the second electric conductors C31 and C32, that the connecting wirings C31b and C32b connected to the branching wirings C31c and C32c are directly connected to the first and the second matching boxes M 1 and M2 and that how the first and the second cases K31 and K32 are constituted.
Other constitutions in the embodiment 3 are almost same as those in the embodiment 1.

In the case of the first case K31, the parts corresponding to the first and the second parts K11a and K 11 b as shown in Fig. 1 is omitted and is solely constituted from the part corresponding to the third part K11c. Similarly, the second case K32 is also constituted only from the part corresponding to the third part K12c.
Since the first matching box M 1 is made to directly contact with the connecting wiring 31b, it is supported at the position of the height H31 by the first supporting part A31 and, since the second matching box M2 is made to directly contact with the connecting wiring C32b, it is supported at the position of the height H32 by the second supporting part A32.

In the case of the embodiment 3, the distances from the first and the second matching boxes M1 and M2 to each of the cathodes 11 are also same. Further, the distance from the first matching box M 1 to each bending part of the first electric conductor C31 and the distance from the second matching box M2 to each bending part of the second electric conductor C32 are same.
The first and the second electric conductors C31 and C32 are constituted as such and, at the same time, positions of the heights of the first and the second matching boxes M1 and M2 are adjusted by the first and the second supporting parts A31 and A32 (H31 - H32 = D).
In accordance with this plasma treating apparatus P3, since the electric power supplying routes from the first and the second matching boxes M 1 and M2 to each cathode 11 are able to be made short, consumption of electric power caused by the wiring resistance of the electric power supplying route is able to be reduced. Further, since numbers of connecting part for different wirings are able to be reduced, electric power consumption caused by the contact resistance is able to be reduced and the first and the second cases K31 and K32 are also able to be made simple.

### (Embodiment 4)

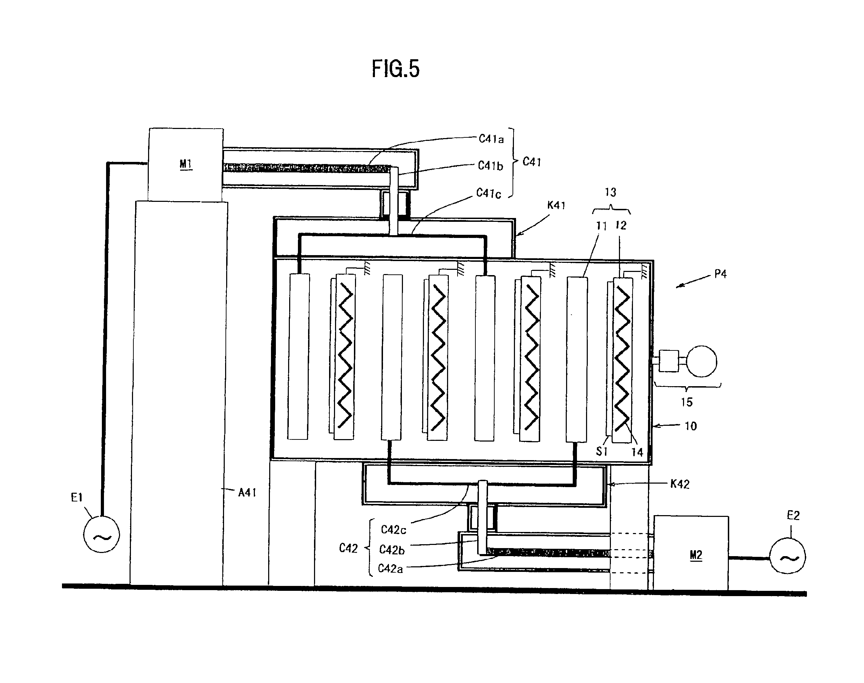

Fig. 5 is a rough constitutional drawing which shows an embodiment 4 of the plasma treating apparatus of the present invention. In Fig. 5, an element which is the same as that in Fig. 1 is assigned with the same reference.
Hereinafter, difference in the embodiment 4 from the embodiment 1 will be mainly illustrated.
The plasma treating apparatus P4 of the embodiment 4 is a plasma treating apparatus of a vertical type for membrane preparation having a leg part and four pairs of cathodes 11 and anodes 12 of the discharging part 13 are vertically aligned in a broadwise long chamber 10 having an opening/closing door (not shown) on the front side wherein each cathode 11 and each anode 12 are supported by a supporting part (not shown) installed in the inner wall of a chamber 10.
The interval between the cathode 11 and the anode 12 of each discharging part 13 and the interval between adjacent two pairs of discharging parts 13 are constituted in the same manner as in the embodiment 1.

In the case of this plasma treating apparatus P4, two branching wirings C41c of the first electric conductor C41 are connected to the upper ends of the first and the third cathodes 11 from the left side while two branching wirings C42c of the second electric conductor C42 are connected to the lower ends of the second and the fourth cathodes 11 from the left side.
Therefore, in the first electric conductor C41, the connecting wiring C41 b is aligned in the vertical direction, the transmitting wiring C41 a is aligned in the horizontal direction, the first matching box M 1 is connected to the transmitting wiring C41 a and the first matching box M1 is supported by a supporting part A41 at a higher position than the chamber 10.
In the second electric conductor C42, the connecting wiring C42b and the transmitting wiring C42a are the same as in the first electric conductor C41 and the second matching box M2 is connected to the transmitting wiring C42a while the second matching box M2 is aligned on the floor.

The first and the second electric conductors C41 and C42 are contained in the first and the second cases K41 and K42 having the same constitution as in the embodiment 1.
In the case of the embodiment 4, the distances from the first and the second matching boxes M1 and M2 to each cathode 11 are also same. In addition, the distance from the first matching box M 1 to each bending part of the first electric conductor C41 and the distance from the second matching box M2 to each bending part of the second electric conductor C42 are same.
Incidentally, although the first case K1 is laid on the upper wall of the chamber 10, it does not apply too much load to the chamber 10 since the first case K41 is not a heavy thing unlike the first matching box M1.

### (Embodiment 5)

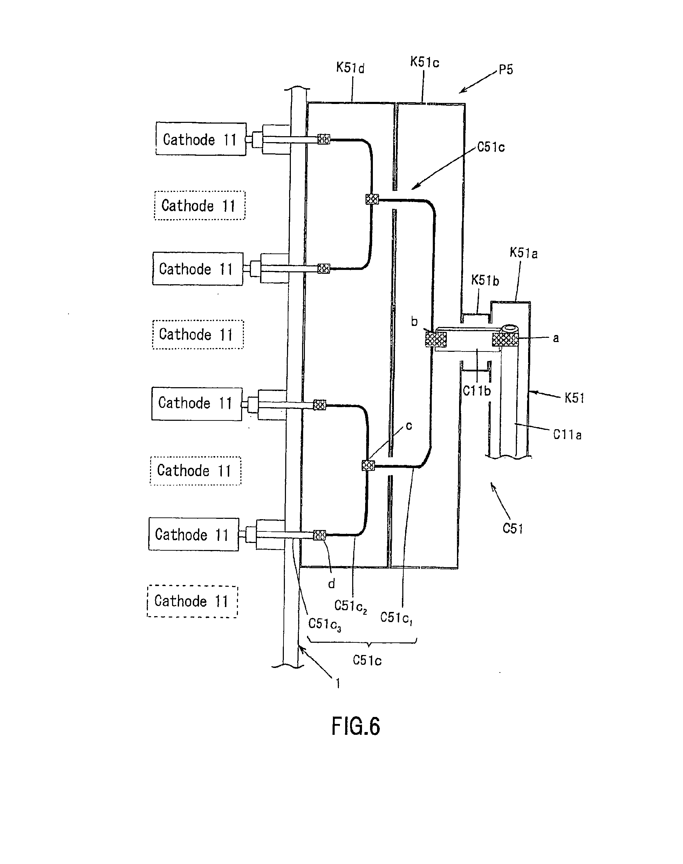

Fig. 6 is a constitutional drawing which shows the first electric conductor and the first case of the plasma treating apparatus of the embodiment 5. In Fig. 6, an element which is the same as that in Fig. 1 is assigned with the same reference.
The difference of the plasma treating apparatus P5 of the embodiment 5 from the embodiment 1 is that each of the numbers of the discharging part, the branched numbers of the branching wiring C51c of the first electric conductor C51 and the branching numbers of the branching wiring of the second electric conductor (not shown) increase to an extent of two times. Other constitutions in the embodiment 5 are the same as those in the embodiment 1.
Hereinafter, the difference in the embodiment 5 from the embodiment 1 will be mainly illustrated.

In this plasma treating apparatus P5, cathodes 11 are aligned in eight steps in a vertical direction. (Anodes are omitted in the drawing).
The first electric conductor C51 is equipped with a transmitting wiring C11a, a connecting wiring C11b and a branching wiring C51c comprising three branched lines C51c₁, C51c₂ and C51c₂.
In the branching wiring C51c, one branched line C51c₁ of the first step is aligned in the connecting wiring C21b side and two branched wires C51c₂ and C51c₂ of the second step are aligned in the cathode 11 side.
Incidentally, in each branched line C51c₂ of the second step, both ends and the midpoint thereof are composed of the different or the same material(s) and they are constituted by being electrically connected by a fastening part "d". In Fig. 6, the terminal part C51c₂ is shown as a part of the branched line C51c_{2.}

In one of the branched lines C51c₂ in the second step, both ends are electrically connected each different cathode 11 via a fastening part "d" and the point being in the same distance from both ends is electrically connected to an end of the above branched line C51c₁ in the first step via a fastening part "c". That is also the same in another branched line C51c₂ in the second step.
In the branched line C51c₁ in the first step, the point being in the same distance from both ends is electrically connected to the connecting wiring C21b via a fastening part b.
Both ends of each branched line C51c₂ in the second step of the first electric conductor C51 are electrically connected to the middle position in the longitudinal direction of an end surface (right end surface) of the first, third, fifth and seventh cathodes 11 from the top.

The first case K51 comprises the first part K51a which contains a transmitting wiring C11a, the second part K51b which contains a connecting wiring C11b, the third part K51c which contains the above branched line C51c₁ in the first step and the fourth part K51d which contains each branched line C51c₂ in the second step.
The second electric conductor (not shown) is same as the first electric conductor C51. However, both ends of each branched line in the second step of the second electric conductor are electrically connected to the middle position in a longitudinal direction of another end surface (left end surface) of the second, fourth, sixth and eighth cathodes 11 from the top.
The second case (not shown) is the same as the first case K51.
In the embodiment 5, distances from the first and the second matching boxes (not shown) to each cathode 11 are also same. Further, the distance from the first matching box to each bending part of the first electric conductor C51 and the distance from the second matching box to each bending part of the second electric conductor are same. In that case, the position of each fastening part in the electric conductor and the folded part of each branched line are the bending parts.

In the embodiment 5, numbers of the discharging parts comprising cathode 11 and anode (not shown) are eight but it is possible to further increase the numbers of the discharging parts by increasing the step number of the branched line to an extent of three or more.
In other words, the plasma treating apparatus of the present invention has matching boxes in the numbers of n (where n is a natural number of 2 or more) together with cathodes in a chamber in the numbers of n × 2^{m} (where m is a natural number) and is able to be constituted in such a manner that each of the matching boxes in the numbers of n is connected to cathodes in the numbers of 2^{m} via an electric conductor.
In the case of the embodiment 5, n is 2 since the numbers of the matching boxes are two and m is 2 since the numbers of the cathodes are eight.
Incidentally, in the case of the above embodiments 1 to 4, n is 2 since the numbers of the matching boxes are two while m is 1 since the numbers of the cathodes are four.
Besides the above, it is also possible in the present invention that, when the numbers of the matching boxes are two for example, cathode numbers are made n × 2^{m} such as 16 or 32.

### (Embodiment 6)

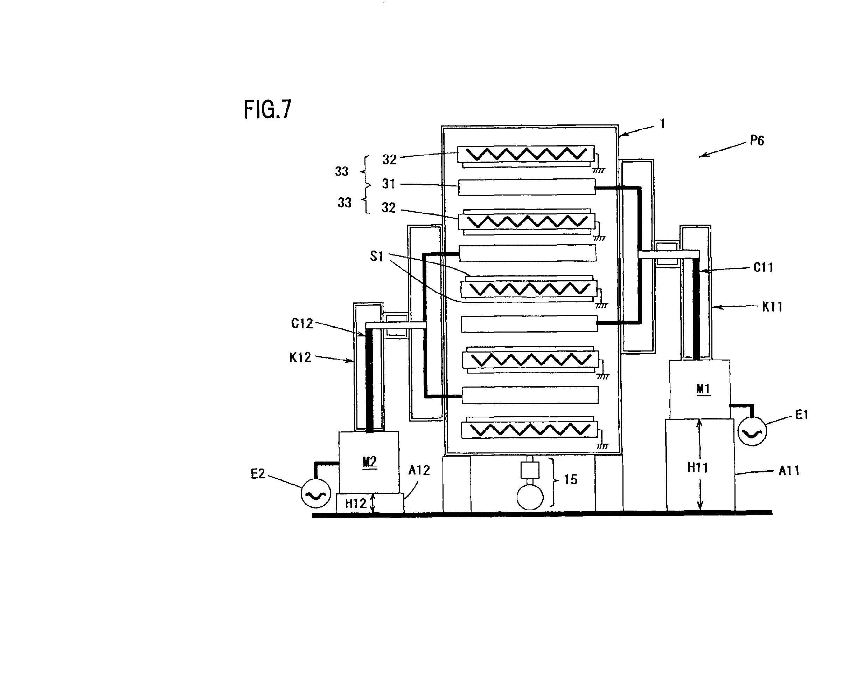

Fig. 7 is a rough constitutional drawing which shows the embodiment 6 of the plasma treating apparatus of the present invention. In Fig. 6, an element which is the same as that in Fig. 1 is assigned with the same reference.
The plasma treating apparatus P6 of the embodiment 6 is a plasma treating apparatus of a horizontal type for membrane formation equipped with four steps of cathodes from upside to downside the same as in the embodiment 1, although the constitutions of cathodes 31 and anodes 32 and the numbers of the anodes 32 are different from the embodiment 1 while other constitution is almost same as that in the embodiment 1.
Hereinafter, the difference in the embodiment 6 from the embodiment 1 will be mainly illustrated.

In the embodiment 6, a cathode 31 has many perforated pores on both upper and lower surfaces and is constituted in such a manner that reactive gas is blown into a chamber 1 from both upper and lower surfaces.
Further, an anode 32 is constituted in such a manner that it is able to support a substrate S 1 on one surface or both upper and lower surfaces. On the lower surface of an anode 32, there is formed a thing (such as a supporting piece in an inverted L shape (not shown)) which is able to support the outer circumference of a substrate S 1 in such a state that the untreated surface of a substrate S1 is closely touched to the lower surface of an anode 32.
In the case of the embodiment 6, an anode 32 is further aligned on the upper area of the cathode 31 in the uppermost step.

In a plasma treating apparatus P6 of the embodiment 6 constituted as such, it has such a structure that all cathodes 31 lie between the anodes 32 whereupon plasma discharge is generated between all cathodes 31 and anodes 32. In Fig. 7, the reference 33 shows a discharging part.
Accordingly, in the treatment for preparing the membrane, substrates S1 are placed on the lower surface of the uppermost anode 32, on the upper surface of the lowermost anode 32 and on both upper and lower surfaces of other anodes 32 and reactive gas is blown out from both upper and lower surfaces of each cathode 31 to each substrate S 1 whereby plasma is generated between each cathode 31 and anode 32.
In the embodiment 6, imbalance of high-frequency electric power supplied from the electric sources E1 and E2 to each cathode 31 is also able to be reduced the same as in the embodiment 1.
Further, according to the embodiment 6, many substrates S1 are able to be treated by one plasma treatment whereby the treating efficiency is enhanced.

### (Embodiment 7)

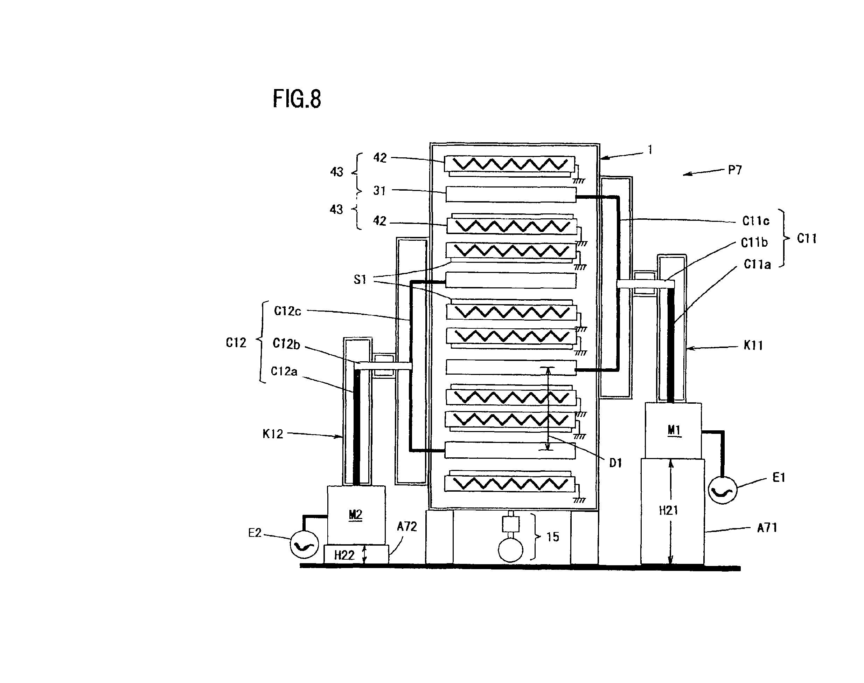

Fig. 8 is a rough constitutional drawing which shows an embodiment 7 of the plasma treating apparatus of the present invention. In Fig. 7, an element which is the same as that in Fig. 1 is assigned with the same reference.
Although the plasma treating apparatus P7 of the embodiment 7 is similar to the plasma treating apparatus P6 of the embodiment 6 (refer to Fig. 7), there is a difference between them in such a respect that two anodes 42 are aligned between the adjacent two cathodes 31. In that case, between the adjacent two cathodes 31, a substrate S1 is installed on the upper surface of the upper anode 42 while a substrate S1 is installed on the lower surface of the lower anode 42.
In the embodiment 7, other constitutions are almost same as those in the embodiments 1 and 6.
Hereinafter, the difference in the embodiment 7 from the embodiments 1 and 6 will be mainly illustrated.

In the embodiment 7, there is installed, on the lower surface of the anode 42 of the lower side between the cathodes 31, an inverted L-shaped supporting piece (not shown) which is able to support the outer circumference of the substrate S1 in such a state that the untreated surface of the substrate S 1 is tightly contacted to the lower surface of the anode 42 the same as in the case of the embodiment 6.
Further, in the case of the embodiment 7, the interval D1 between the cathodes 31 is broader than the interval D between the cathodes 11 in the embodiment 1 (refer to Fig. 1). Accordingly, although the first electric conductor C 11 and the second electric conductor C 12 are same in the embodiment 7, a gap corresponding to the interval D1 between the adjacent two cathodes 31 is available between the height of the connecting part of the branching wiring C11c to the connecting wiring C11b in the first electric conductor C 11 and the height of the connecting part of the branching wiring C12c to the connecting wiring C 12b in the second electric conductor C12.
Accordingly, the height H21 of the first supporting part A71 is made higher than the height H12 of the second supporting part A72 to an extent of the above interval D1. In other words, H21 - H22 = D 1.

In a plasma treating apparatus P7 of the embodiment 7 constituted as such, it also has such a structure that all cathodes 31 lie between anodes 42, reaction gas is blown out from both surfaces of each cathode 31 and plasma discharge is generated between all cathodes 31 and anodes 32. In Fig. 8, the reference 43 shows a discharging part.
In the embodiment 7, it is also possible that imbalance of high-frequency electric power supplied to each cathode 31 from the electric sources E1 and E2 is reduced and further that much more substrates S1 are efficiently treated by one plasma treatment.

### (Embodiment 8)

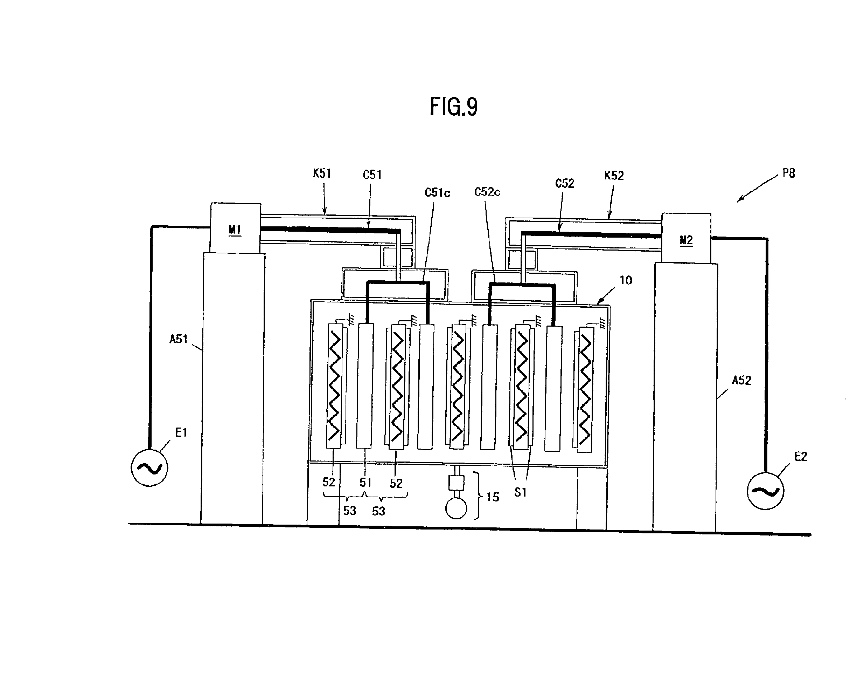

Fig. 9 is a rough constitutional drawing which shows an embodiment 8 of the plasma treating apparatus of the present invention. In Fig. 9, an element which is the same as that in Fig. 5 is assigned with the same reference.
Although the plasma treating apparatus P8 of the embodiment 8 is a plasma treating apparatus of a vertical type for membrane formation where cathodes 51 are aligned in four steps in a vertical direction as same as in the plasma treating apparatus P4 (refer to Fig. 5) of the embodiment 4, it is different from the embodiment 4 in terms of the constitutions of cathode 51 and anode 52, the numbers of anode 52 and the connection of the same branching wiring to adjacent two cathodes 51 while other constitutions are almost as same as those in the embodiment 4.
Hereinafter, the difference in the embodiment 8 from the embodiment 4 will be mainly illustrated.

In the embodiment 8, the cathode 51 is in such a constitution that many perforated pores are formed on both left and right sides so that reactive gas is blown out from both left and right sides into a chamber 10.
Further, the anode 52 is constituted in such a manner that one side or both left and right sides thereof is/are able to support the substrate S1.
On one side or both left and right sides of the anode 52, there is/are installed supporting piece(s) (not shown) in, for example, an inverted L-shape which is/are able to support the outer circumference of the substrate S1 in such a state that the non-treated surface of the substrate S1 is tightly contacted thereto.
Furthermore, in the case of the embodiment 8, there is such a structure that all cathodes 51 lie between anodes 52, that reaction gas is blown out from both left and right surfaces of each cathode 51 and that plasma discharge is generated between all cathodes 51 and anodes 52. In Fig. 9, the reference 53 shows a discharging part.

Still further, in the case of the embodiment 8, the first and the second electric conductors C51 and C52 and the first and the second cases K51 and K52 containing them are aligned on the upper area of a chamber 10 while the first and the second matching boxes M1 and M2 and the first and the second supporting parts A51 and A52 supporting them are aligned on both sides of a chamber 10. Still furthermore, both ends of the branching wiring C51c of the first electric conductor C51 are electrically connected to the upper end of the adjacent.two cathodes 51 on the left side while both ends of the branching wiring C52c of the second electric conductor C52 are electrically connected to the upper end of the adjacent two cathodes 51 on the right side.

The embodiment 8 is also able to reduce the imbalance of high-frequency electric power supplied to each cathode 51 from the electric sources E1 and E2 and to efficiently treat much more substrates S 1 by one plasma treatment.
Although the embodiment 8 shown by Fig. 9 exemplifies a plasma treating apparatus where the supporting parts A51 and A52 are aligned on both left and right sides of the chamber 10, it is also possible to constitute a plasma treating apparatus in such a manner that both supporting parts A51 and A52 are aligned together behind the chamber 10. In doing as such, it is possible to prepare a plasma treating apparatus having matching boxes in the numbers of n (n: natural number of 3 or more) and also having cathodes in the numbers of n × 2^{m} (m: natural number) in a chamber. That is the same in the following embodiment 9 as well.

### (Embodiment 9)

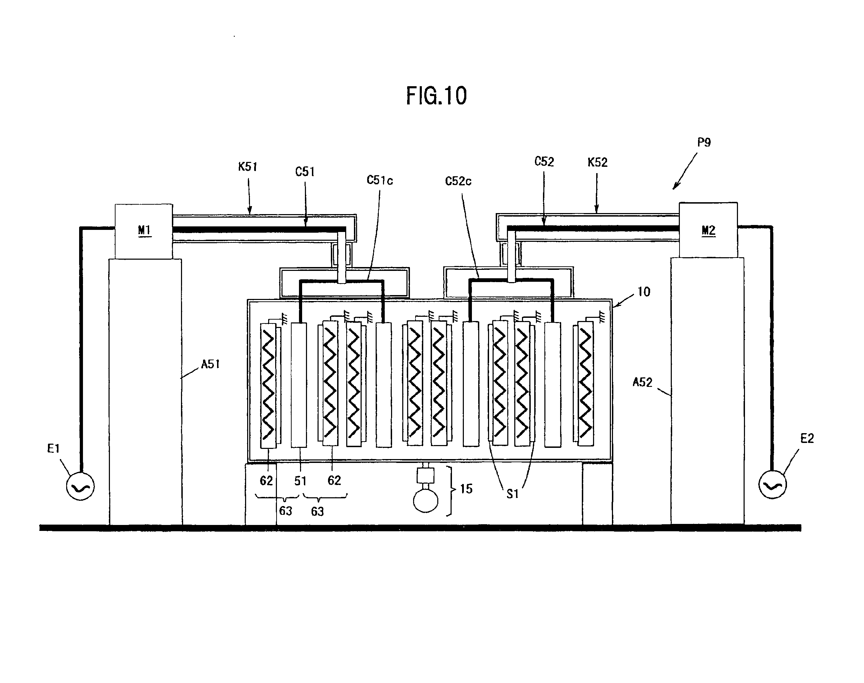

Fig. 10 is a rough constitutional drawing which shows an embodiment 9 of the plasma treating apparatus of the present invention. In Fig. 10, an element which is the same as that in Figs. 1 and 9 is assigned with the same reference.
The plasma treating apparatus P9 of the embodiment 9 is similar to the plasma treating apparatus P8 (refer to Fig. 9) of the above embodiment 8 and the different points are that two anodes 62 are aligned between the adjacent left and right cathodes 51 and that a substrate S1 is placed on the side of each anode 62 facing to a cathode 51. In the embodiment 9, other constitutions are almost the same as those in the embodiment 8.

In the plasma treating apparatus P9 of the embodiment 9 constituted as such, it also has such a structure that all cathodes 51 lie between anodes 62, that reaction gas is blown out from both sides of each cathode 51 and that plasma discharge is generated between all cathodes 51 and anodes 62. In Fig. 10, the reference 53 shows a discharging part.
It is possible in the embodiment 9 as well that imbalance of high-frequency electric power supplied from the electric sources E1 an E2 to each cathode 51 and that much more substrates S 1 are efficiently treated by one plasma treatment.

### (Embodiment 10)

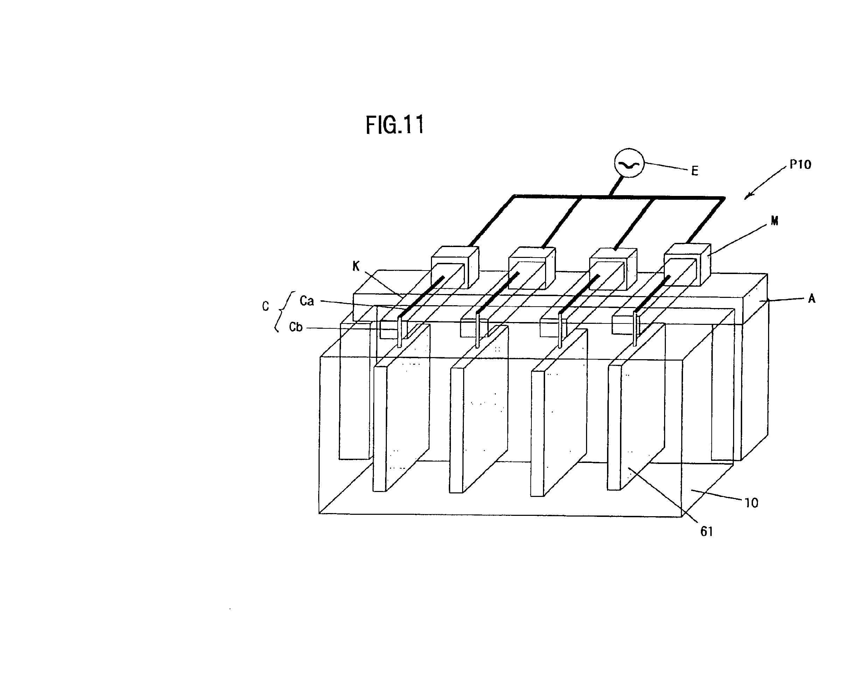

Fig. 11 is a rough constitutional drawing which shows the embodiment 10 of the plasma treating apparatus of the present invention. In Fig. 10, anode and exhaust pipe are not shown.
Although the plasma treating apparatus P10 of the embodiment 10 is a plasma treating apparatus of a vertical type for membrane formation where cathodes 61 are aligned in four steps in a vertical direction the same as in the plasma treating apparatuses of the embodiments 8 and 9, its electric power supplying structure is different from that of the embodiments 8 and 9 while other constitutions are almost the same as those in the embodiments 8 and 9.
Hereinafter, the difference in the embodiment 10 from the embodiments 8 and 9 will be mainly illustrated.

The plasma treating apparatus P10 of the embodiment 10 is equipped with an electric source part E, four matching boxes M electrically connected via an electric power supplying route branched from the electric source part E, an electric conductor C which electrically connects each matching box with each cathode 61 in 1:1 and a common supporting part A which supports all matching boxes M in the same height.
The electric conductor C comprises a transmitting wiring Ca and a connecting wiring Cb and is contained in a case K.
Each of the electric conductors C is same and is contained in the same case K.
Constitutions and alignments of cathode 61 and anode are the same as those in the embodiment 4 (Fig. 5), the embodiment 8 (Fig. 9) or the embodiment 9 (Fig. 10).

Since a cathode 61 and a matching box M are able to be connected in 1:1 according to the plasma treating apparatus P10 of the embodiment 10, a plasma treatment of a substrate by other discharging part is able to be carried out even under such a state where only cathode or anode in the discharging part in which any defect happens is taken out from the chamber.
In Fig. 11, a common supporting part which supports all matching boxes M in the same height is exemplified as a supporting part A but, since there is no problem provided that all matching boxes M are supported in the same height, each matching box M may be supported by separate supporting parts or each plural matching boxes M may be supported by a common supporting part.

The embodiments disclosed hereinabove are just exemplifications and the present invention is not limited to the above-mentioned ones only. The scope of the present invention is represented by the claims and is intended to cover all variations within the equivalent meaning to and within the scope of the claims.

In accordance with the plasma treating apparatus of the present invention and the plasma treating method using the same, it is now possible to supply a method for the manufacture of a semiconductor device whereby semiconductor devices having a desired device characteristics such as thin-membrane solar batteries, TFT or photosensitive materials using thin-membrane semiconductor or optical thin membrane are able to be produced in a stable manner suppressing the imbalance.

### DESCRIPTION OF THE REFERENCE NUMERALS

- 1, 10: chamber
- 11, 21, 31, 51: cathode
- 12, 22, 32, 42, 52, 62: anode
- 13, 23, 33, 43, 53, 63: discharging part A
- A11, A21, A31, A41, A51, A71: first supporting part
- A 12, A22, A32, A52, A72: second supporting part
- C: electric conductor
- C11, C21, C31, C41, C51: first electric conductor
- C11a, C12a, C41a, C42a: transmitting wiring
- C11c, C12c, C31c, C32c, C41c, C42c: branching wiring
- C11b, C12b, C31b, C32b, C41b, C42b: connecting wiring
- C12, C22, C32, C42, C52: second electric conductor
- C51c, C52c: branching wiring
- C51c₁, C51c₂: branched line
- E1,: E2 electric source part
- K: case
- K11, K21, K31, K41, K51: first case
- K12, K22, K32, K42, K52: second case
- M1: first matching box
- M2: second matching box
- P1, P2, P3, P4, P5, P6, P7, P8, P9, P10: plasma treating apparatus
- S1, S2: substrate

## Claims

1. A plasma treating apparatus comprising:
a sealable chamber into which a reactive material gas is introduced;
plural sets of discharging parts, each set having a cathode and an anode aligned in an opposite manner in the chamber to generate a plasma discharge;
an electric source part positioned outside the chamber to supply electric power for generating the plasma discharge in the plural sets of discharging parts;
a plurality of matching boxes positioned outside the chamber, the matching boxes electrically connected to the electric source part;
at least a supporting part positioned outside the chamber, the supporting part supporting the plural matching boxes; and
a plurality of electric conductors which electrically connect the plural matching boxes to the cathodes of the plural sets of discharging parts,
wherein the supporting part is adapted to support one or more of the matching boxes at a position where the plurality of electric conductors are equal in length.

2. The plasma treating apparatus according to Claim 1, wherein the supporting part is installed on the floor of a place where the plasma treating apparatus is installed and has a fixed stand or a height-adjustable elevating stand by which the matching box is able to be supported at the height being able to make the lengths of a plurality of electric conductors same.

3. The plasma treating apparatus according to Claim 1 or 2, wherein the plasma treating apparatus has the matching boxes in the numbers of "n" (n is a natural number of 2 or more) and, in the chamber, there are the cathodes in the numbers of "n × 2^{m}" (m is a natural number) and each of the matching boxes in the numbers of "n" is connected to the cathodes in the numbers of "2^{m}" via the electric conductor.

4. The plasma treating apparatus according to any one of Claims 1 to 3, wherein the electric conductor comprises a transmitting wiring, a connecting wiring and a branching wiring, each of both ends of the branching wiring is electrically connected to the cathode each being different, an end of the transmitting wiring is electrically connected to the matching box, an end of the connecting wiring is electrically connected to another end of the transmitting wiring and another end of the connecting wiring is electrically connected to the point being in the same distance from both ends of the branching wiring.

5. The plasma treating apparatus according to any one of Claims 1 to 3, wherein the electric conductor comprises a connecting wiring and a branching wiring, each of the both ends of the branching wiring is electrically connected to the cathode each being different, an end of the connecting wiring is electrically connected to an end of the matching box and another end of the connecting wiring is electrically connected to the point being in the same distance from the both ends of the branching wiring.

6. The plasma treating apparatus according to Claim 4 or 5, wherein the branching wiring is constituted in m stages from the connecting wiring side to the cathode side by branched lines in the numbers of 2^{m-1} (m is a natural number),
both ends of each of the branching wirings except that of the m-th stage are electrically connected to a point being in the same distance from both ends of the branched line of the next stage each being different and
both ends of the branching wiring of the m-th stage are electrically connected to cathodes each being different.

7. The plasma treating apparatus according to Claim 1 or 2, wherein the electric conductor comprises a connecting wiring and a transmitting wiring, an end of the transmitting wiring is electrically connected to the matching box, an end of the connecting wiring is electrically connected to another end of the transmitting wiring and another end of the connecting wiring is electrically connected to the cathode.

8. The plasma treating apparatus according to any one of Claims 1 to 7, wherein each of the above plural different electric conductors is constituted from the same material and structure as a whole.

9. The plasma treating apparatus according to any one of Claims 1 to 8, wherein a part of or all of the plural electric conductors is/ are constituted from those in a form of tube, plate or square rod.

10. The plasma treating apparatus according to any one of Claims 1 to 9, wherein the electric conductor comprises a metal material containing at least one of copper, aluminum, nickel, silver, gold and tin.

11. The plasma treating apparatus according to any one of Claims 1 to 10 further comprises a case which contains a part of or all of the above electric conductors.

12. A plasma treating method wherein a substrate is placed at the discharging part in the plasma treating apparatus according to any one of Claims 1 to 11 so that a semiconductor membrane is layered on the surface of the substrate.

13. A plasma treating method wherein a substrate having a semiconductor membrane on the surface is placed at the discharging part in the plasma treating apparatus according to any one of Claims 1 to 11 so that the semiconductor membrane on the substrate is etched.

14. A manufacturing a semiconductor device wherein a semiconductor device is formed on the substrate using the plasma treating method according to Claim 12 or 13.
